# EUROPEAN PATENT APPLICATION

(11) **EP 4 585 945 A1**
(43) Date of publication of application: **16.07.2025**
(21) Application number: 23877517.5
(22) Date of filing: 14.09.2023
(51) Int. Cl.: G01R 31/374, G01R 31/36, G01R 31/389, G01R 31/364, G01R 23/00, H01M 10/48, H01M 10/42

(54) **CORRECTION DEVICE AND CORRECTION METHOD FOR CORRECTING INITIAL VALUE OF IMPEDANCE SPECTRUM MEASUREMENT DEVICE**

(30) Priority: 14.10.2022 KR 20220132747
(71) Applicant: LG Energy Solution, Ltd., Seoul 07335 (KR)
(72) Inventor: KIM, Ki Hyun, Daejeon 34122 (KR)
(74) Representative: Plasseraud IP
(86) International application number: PCT/KR2023/013835
(87) International publication number: WO 2024/080588

(57) **Abstract**

The present invention relates to a correcting device for correction of a measuring device that measures an impedance spectrum, the correcting device including:
a first plate including a first connecting part electrically connected to a first electrode of the measuring device; a second plate including a second connecting part electrically connected to a second electrode of the measuring device; and a reference unit mounted on the first plate and having a predetermined inherent value, wherein the first connecting part and the second connecting part are electrically connected to each other through the reference unit.

## Description

### TECHNICAL FIELD

### CROSS-REFERENCE TO RELATED APPLICATION

The present application claims the benefit of the priority of Korean Patent Application No. 10-2022-0132747, filed on October 14, 2022, which is hereby incorporated by reference in its entirety.

### TECHNICAL FIELD

The present invention relates to a correcting device and correcting method for initial value correction of an electrochemical impedance spectrum measuring device for diagnosing a state of a battery cell.

### BACKGROUND ART

Non-destructive diagnosis methods as methods for diagnosing states of batteries include electrochemical impedance spectroscopy (EIS). The electrochemical impedance spectroscopy is a method for analyzing impedance by applying minute sinusoidal current and voltage signals to a range from a high-frequency range even to a low-frequency range, and then measuring amplitude and phase variations based on voltage and current signals in response to the applied signals in a range in which batteries are in electrical equilibrium and thermal equilibrium. The sinusoidal signals may be applied to a range from high frequencies to low frequencies, and impedance for each frequency may be derived through response signals generated in response to the applied signals. As the electrochemical impedance spectroscopy is a method for analyzing internal mechanism by using frequency regions, there are advantages that states of components included in a battery system, i.e., positive electrodes, negative electrodes, separators, electrolytes, and the like, may be separately analyzed for each frequency region.

As electrochemical impedance measuring devices sensitively respond to subtle changes in current and voltage signals, it is important that prior to measuring impedance spectra of battery cells, initial values of the measuring devices be accurately set to minimize potential errors. Thus, it needs to be checked whether the initial values set in the measuring devices are accurately set, and as a result of the checking, if the initial values are inaccurately set, the preset initial values need to be corrected. Here, when measuring the impedance spectra by using the battery cells in order to check whether the set initial values are accurately set, changes in components inside the battery cells per time may occur in the measuring devices that sensitively respond to even subtle changes in current and voltage. Accordingly, there are problems that as errors occur in output signals, and these errors are accumulated, it is difficult to check whether or not the set initial values are accurate.

### DISCLOSURE OF THE INVENTION

### TECHNICAL PROBLEM

An object of the present invention for solving the above problems is to provide a correcting device and correcting method for initial value correction of a measuring device for measuring an impedance spectrum, the correcting device and correcting method being capable of checking whether an initial set value of the measuring device is accurately set, and calculating a correction value so that when the initial set value is inaccurately set, the initial set value is corrected.

### TECHNICAL SOLUTION

According to one embodiment of the present invention, the present invention provides a correcting device for correction of a measuring device that measures an impedance spectrum, the correcting device including: a first plate including a first connecting part electrically connected to a first electrode of the measuring device; a second plate including a second connecting part electrically connected to a second electrode of the measuring device; a reference unit mounted on the first plate and having a predetermined electrical numerical value, wherein the first connecting part and the second connecting part are electrically connected to each other through the reference unit.

The reference unit may be configured so that the impedance spectrum is measured by the measuring device.

The first plate may further include a fixing unit electrically connected to the first connecting part through the reference unit, and the second plate may further include a connection unit that is in contact with the fixing unit to electrically connect the fixing unit to the second connecting part.

The connection unit may be in contact with the fixing unit.

A slide hole may be defined in the connection unit in a longitudinal direction, a coupling unit may be inserted into the slide hole, and the inserted coupling unit may be coupled to the fixing unit.

The reference unit may be a capacitor.

The first plate may further include a mounting part in which an accommodation space in which the reference unit is mounted is defined.

The first plate may further include a guide unit disposed in a longitudinal direction of the first plate, and disposed below the connection unit.

The guide unit may have a height that is the same as a height of the fixing unit.

Each of the fixing unit and the connection unit may include a metal member.

As another embodiment of the present invention, the present invention provides a correcting method for correction of a measuring device that measures an impedance spectrum, the correcting method including: connecting a first electrode and a second electrode of the measuring device to a first connecting part and a second connecting part of the correcting device, respectively; applying a sinusoidal input signal to a reference unit, which electrically connects the first connecting part to the second connecting part, through the measuring device; and outputting an output signal including the impedance spectrum in response to the applied input signal.

The correcting method may further include comparing and calculating a correction value with a predetermined electrical numerical value of the reference unit in response to the output signal, and then correcting the measuring device to the correction value.

The output signal may include one or more of a Bode plot and a Nyquist plot.

As still another embodiment of the present invention, the present invention provides a measuring device assembly including: a measuring device that measures an impedance spectrum; a jig structure electrically connected to each of a first electrode and a second electrode of the measuring device; and a correcting device coupled to the jig structure, wherein the correcting device includes: a first plate including a first connecting part electrically connected to the first electrode of the measuring device; a second plate including a second connecting part electrically connected to the second electrode of the measuring device; a reference unit mounted on the first plate and having a predetermined electrical numerical value, wherein the first connecting part and the second connecting part are electrically connected to each other through the reference unit.

### ADVANTAGEOUS EFFECTS

In the device and method for correcting the initial value for the correction of the measuring device that measures the impedance spectrum according to the present invention, the capacitor stable for the changes in internal components may be used to obtain the more accurate correction value, and the electrical connection may be achieved through not the lead wire but the metal member to minimize the noise included in the output signal.

### BRIEF DESCRIPTION OF THE DRAWINGS

FIG. 1 is a view illustrating a configuration in which a battery cell is combined with a measuring device for measuring an impedance spectrum.
FIG. 2 is a perspective view illustrating a configuration in which a correcting device, a measuring device for measuring an impedance spectrum, and a jig structure are combined according to an embodiment of the present invention.
FIG. 3 is a plan view illustrating a structure of a correcting device according to an embodiment of the present invention.
FIG. 4 is a plan view illustrating a correcting device provided with one reference unit, a manner in which a negative electrode pin and a positive electrode pin that are provided in the reference unit are coupled to each of a linking unit and a coupling unit through lead wires, and a method for adjusting a spaced distance between a first plate and a second plate according to an embodiment of the present invention.
FIG. 5 is a plan view illustrating a correcting device provided with two reference units, a manner in which a negative electrode pin and a positive electrode pin that are provided in each of the reference units are coupled to each of a linking unit and a coupling unit through lead wires, and a method for adjusting a spaced distance between a first plate and a second plate according to another embodiment of the present invention.
FIG. 6 is a view illustrating a configuration in which a fixing unit, a connection unit, and the first plate are combined through the coupling unit in a portion "A" in FIG. 4 when viewed from a side.
FIG. 7 is an enlarged view illustrating a pattern groove of the linking unit and a pattern groove of a second connecting part in portions "B" and "C" in FIG. 4.
FIG. 8 is a perspective view illustrating a configuration in which a negative electrode pin and a positive electrode pin that are provided in a reference unit are connected to each of a linking unit and a fixing unit through lead wires according to an embodiment of the present invention.
FIGS. 9 and 10 are a plan view and a front view illustrating a configuration in which a reference unit is connected to a linking unit and a fixing unit through a connecting unit according to another embodiment of the present invention.

### MODE FOR CARRYING OUT THE INVENTION

Hereinafter, the present invention will be described in more detail with reference to the accompanying drawings. The accompanying drawings are included to provide a further understanding of the present invention, and illustrate merely an embodiment of the present invention. The scope of the present invention is not limited by the drawings. In the accompanying drawings, like reference numerals refer to like elements throughout. Some components may be exaggerated, reduced, or omitted to easily understand the present invention.

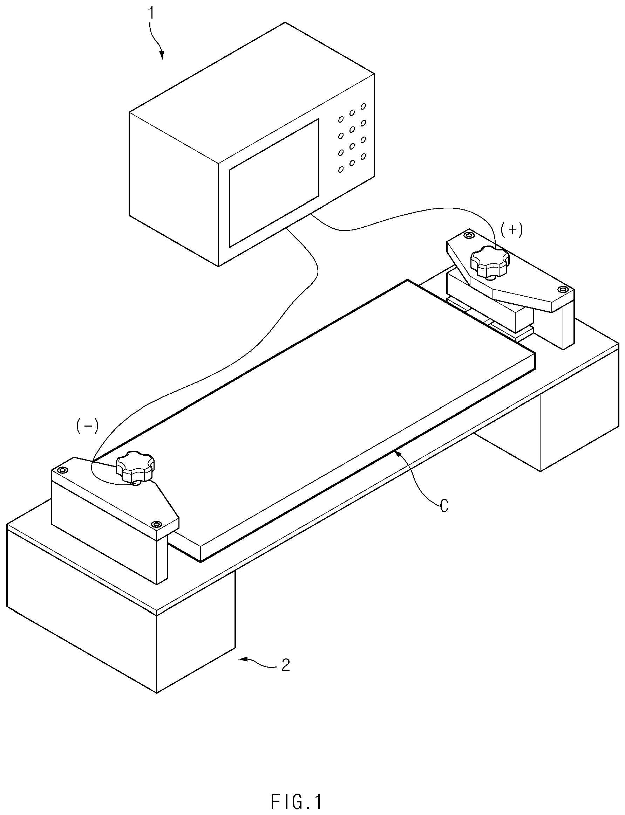

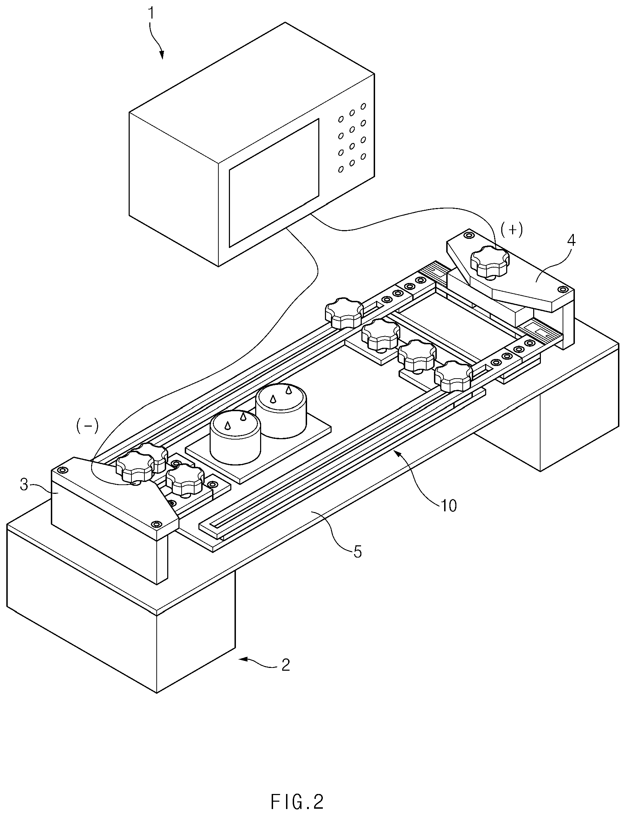

Referring to FIGS. 1 and 2, the present invention relates to a correcting device 10 for initial value correction of a measuring device 1 for measuring an impedance spectrum, and a battery cell C or the correcting device 10 may be coupled to a jig structure 2 electrically connected to a first electrode and a second electrode of the measuring device 1. The measuring device 1 may apply minute sinusoidal current and voltage signals to a range from a high-frequency range even to a low-frequency range to visually display an output signal.

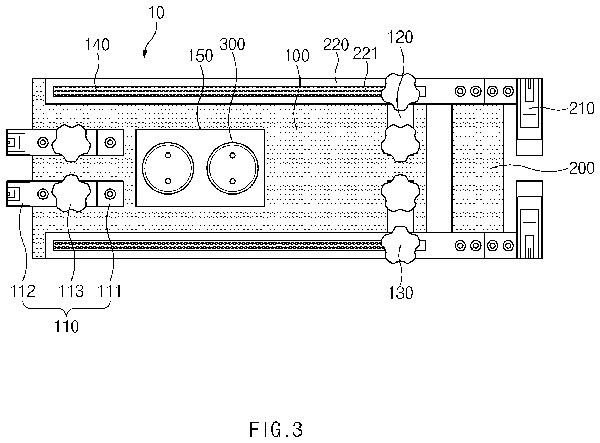

Referring to FIG. 3, the correcting device 10 may include a first plate 100, a second plate 200, and a reference unit 300.

The first plate 100 may have a predetermined thickness, and be provided in the form of a flat plate so that other components are disposed thereon.

The first plate 100 may include a first connecting part 110, a fixing unit 120, a coupling unit 130, a guide unit 140, and a mounting part 150. The first connecting part 110, the fixing unit 120, the coupling unit 130, and the guide unit 140 may be disposed on one surface of the first plate 100. In addition, the mounting part 150 may be provided on the one surface of the first plate 100. The first plate 100 may include an electrical insulation material so that electricity does not flow therethrough.

The first connecting part 110 may be disposed at one side on the one surface of the first plate 100 to be electrically connected to the first electrode of the measuring device 1. In addition, the first connecting part 110 may function to electrically connect the reference unit 300 to the first electrode of the measuring device 1.

The first connecting part 110 may include a support unit 111, a linking unit 112, and a fastening unit 113.

The support unit 111 may separate a top surface of the first plate 100 and the linking unit 112, through which electricity may flow, by a thickness thereof to prevent electricity from flowing directly through the first plate 100.

The support unit 111 may have an end that is disposed so as not to go beyond an area of the top surface of the first plate 100, and the linking unit 112 coupled to the support unit 111 may protrude outward from the first plate 100. Accordingly, the linking unit 112 may be coupled to a first electrode coupling part of the jig structure 2 of the measuring device 1.

The linking unit 112 may be disposed on a top surface of the support unit 111, and at least a portion thereof may protrude outward from an area of the top surface of the first plate 100. The protruding portion may be coupled to the jig structure 2 of the measuring device 1.

The linking unit 112 may include an electrically conductive metal material so that electricity flows therethrough toward the first electrode or from the first electrode. For example, the linking unit 112 may include one or more of silver, copper, gold, aluminum, and tungsten, but is not limited thereto.

The linking unit 112 may include a metal member in the form such as a metal piece, a metal bar, a metal rod, a metal stick, or a metal plate, which has a predetermined thickness and width. In this case, compared when connected in the form of a general wire, the linking unit 112 may have a larger horizontal cross-sectional area to reduce electric resistance, and due to less movement, noise may be minimized from being input into the measuring device 1 for measuring the impedance spectrum, which outputs a signal sensitively to even a subtle flow of current.

The linking unit 112 may be provided in plurality, and the plurality of linking unit 112 may be disposed to be spaced a predetermined distance from each other on a plurality of support units 111, which are spaced a predetermined distance from each other, respectively. As the linking unit 112 is provided in plurality, the linking units 112 may be electrically connected to the reference unit 300 through a 4-wire resistive connection method. Accordingly, values of resistance, etc., generated due to the lead wires through which the measuring device 1 is electrically connected to the reference unit 300 may be minimized to accurately measure a very small impedance value of the reference unit 300.

A horizontal cross-section of the linking unit 112 may have, for example, a polygonal shape such as square, rectangle, pentagon, or hexagon, a closed curve figure such as a circular shape or an oval shape, or the like, but the shape thereof is not limited thereto.

A pattern groove 112a having a predetermined pattern may be defined in an end of one surface or each of both surfaces of the linking unit 112. When the linking unit 112 is connected to a first electrode connecting part of the measuring device 1, the pattern groove 112a may create friction to improve physical coupling force between the linking unit 112 and the first electrode connecting part of the measuring device 1. In addition, the pattern groove 112a may increase a contact area with the first electrode connecting part of the jig structure 2 of the measuring device 1 so as to allow current to flow well.

The fastening unit 113 may fasten the linking unit 112 onto the support unit 111 to fix the linking unit 112 to the support unit 111. The fastening unit 113 may provide a screw protrusion having a spiral shape continuous along a circumference of a body part 113b, and thus may adjust a level of the fastening force to more strongly or weakly fasten the fastening unit 113 according to a rotation direction in which the fastening unit 113 is rotated. According to cases, the fastening unit 113 may be separated from the linking unit 112 and the support unit 111.

The fastening unit 113 may include a head part 113a and the body part 113b. The head part 113a may be coupled to an upper portion of the body part 113b, and when the head part 113a is gripped by fingers and then rotated in a clockwise direction or a counterclockwise direction, the body part 113b may also rotate in the same direction as the rotation direction of the head part 113a. The head part 113a may include a material such as plastic, which is an electrical insulation material. The body part 113b may be made of a metal material having high electrical conductivity, and thus the body part 113b and the linking unit 112 may be in contact with and electrically connected to each other.

The body part 113b and the reference unit 300 may be electrically connected to each other through lead wires, and accordingly, the linking unit 112 and the reference unit 300 may also be electrically connected to each other.

The fixing unit 120 may be coupled onto one surface of the first plate 100, and may be in contact with and electrically connected to a connection unit 220 fastened to the second plate 200.

The fixing unit 120 may electrically connect the reference unit 300 and the connection unit 220, which will be described later, to each other, and may include an electrically conductive metal material so that electricity flows therethrough. For example, the fixing unit 120 may include one or more of silver, copper, gold, aluminum, and tungsten, but is not limited thereto.

The fixing unit 120 may have a predetermined thickness and width, and may include a metal member in the form of, for example, a metal piece, a metal bar, a metal rod, a metal stick, or a metal plate. In this case, compared when connected in the form of a general wire, the fixing unit 120 may have a larger horizontal cross-sectional area to reduce electric resistance, and due to less movement, noise may be minimized from being input into the measuring device 1 for measuring the impedance spectrum, which outputs a signal sensitively to even a subtle flow of current.

A horizontal cross-section of the fixing unit 120 may have, for example, a polygonal shape such as square, rectangle, pentagon, or hexagon, a closed curve figure such as a circular shape or an oval shape, or the like, but the shape thereof is not limited thereto.

The fixing unit 120 may be disposed at the other side, which is opposite to the one side at which the first connecting part 110 is disposed, on the one surface of the first plate 100.

The fixing unit 120 may be provided in plurality, and the plurality of fixing units 120 may be disposed to be spaced a predetermined distance from each other on the one surface of the first plate 100. As the fixing unit 120 is provided in plurality, the fixing units 120 may be electrically connected to the reference unit 300 through a 4-wire resistive connection method. Accordingly, values of resistance, etc., generated due to the lead wires through which the measuring device 1 is electrically connected to the reference unit 300 is provided may be minimized to accurately measure a very small impedance value of the reference unit 300.

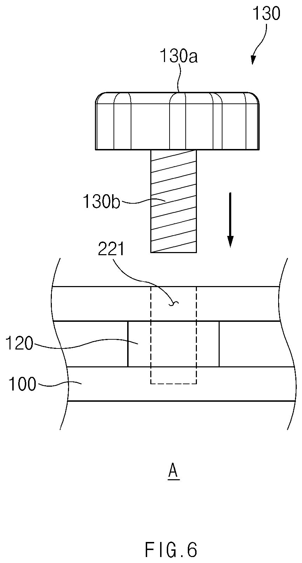

Referring to FIG. 6, the coupling unit 130 may be provided in plurality to be coupled to the fixing unit 120. The coupling unit 130 may couple the fixing unit 120 to the first plate 100, or may be inserted into a slide hole 221 to couple the fixing unit 120 to the first plate 100 so that the fixing unit 120 and the connection unit 220 are in contact with each other.

The coupling unit 130 may have the same structure and shape as the fastening unit 113, and may include a head part 130a and a body part 130b. The head part 130a and the body part 130b of the coupling unit 130 may correspond to the head part 113a and the body part 113b of the fastening unit 113, respectively.

The body part 130b may provide a screw protrusion having a spiral shape continuous along a circumference of the body part 130b, and thus may adjust a level of the fastening force to more strongly or weakly fasten the coupling unit 130 according to a rotation direction in which the coupling unit 130 is rotated. According to cases, the coupling unit 130 may be separated from the fixing unit 120 and the first plate 100.

The coupling unit 130 may include the head part 130a and the body part 130b. The head part 130a may be coupled to an upper portion of the body part 130b, and when the head part 130a having a faceted shape is gripped by fingers and then rotated in a clockwise direction or a counterclockwise direction, the body part 130b may also rotate in the same direction as the rotation direction of the head part 130a. The head part 130a may include a material such as plastic, which is an electrical insulation material. The body part 130b may be made of a metal material having high electrical conductivity, and thus the body part 130b and each of the fixing unit 120 and the connection unit 220 may be in contact with and electrically connected to each other.

The body part 130b and the reference unit 300 may be electrically connected to each other through lead wires. Accordingly, the fixing unit 120 and the reference unit 300 may also be electrically connected to each other.

The guide unit 140 may be provided in at least one. The guide unit 140 may be disposed on the top surface of the first plate 100 in a longitudinal direction of an edge at one side or each of both sides of the first plate 100, and be disposed to be adjacent to one end of the fixing unit 120.

The guide unit 140 may be disposed between the first plate 100 and the connection unit 220. The guide unit 140 may extend to be parallel to the connection unit 220.

When the connection unit 220 is in contact with the fixing unit 120 to slide, the guide unit 140 may be in contact with a bottom surface of the connection unit 220 so as to guide the connection unit 220 to slide while maintaining a height at which the connection unit 220 is positioned.

The guide unit 140 may have a height that is the same as a height of the fixing unit 120.

The guide unit 140 may include an electrical insulation material through which electricity does not flow, so that current flowing through the connection unit 220 does not flow to the first plate 100.

The fixing unit 120 may be disposed on one end in a longitudinal direction of the guide unit 140. The guide unit 140 and the fixing unit 120 may be disposed to have a bending shape, but are not limited thereto.

The mounting part 150 may be disposed on one surface of the first plate 100, and be a region for mounting the reference unit 300.

An accommodation space in which the reference unit 300 may be accommodated may be defined in the mounting part 150.

The mounting part 150 may be disposed between the first connecting part 110 and the fixing unit 120 so that the reference unit 300 electrically connect the first electrode and the second electrode of the measuring device 1 to each other.

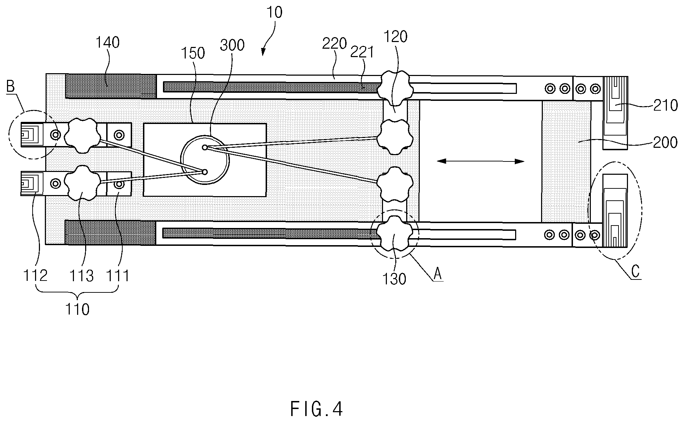

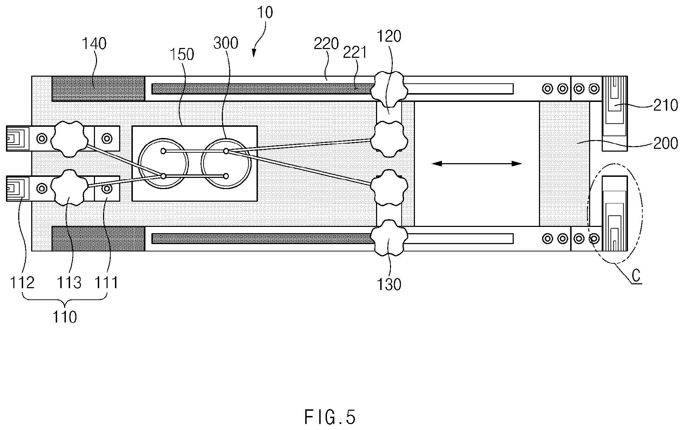

Referring to FIGS. 4 and 5, the second plate 200 may adjust a spaced distance from the first plate. Accordingly, a size of the correcting device 10 may be adjusted so that the correcting device 10 is coupled to match a size of a coupling space of the correcting device, which is defined the jig structure 2 of the measuring device 1. The second plate 200 may be provided with a second connecting part 210 connected to the second electrode of the measuring device 1. The connection unit 220 may be fastened to the second plate 200. The second plate 200 may move together with the connection unit 220. The second plate 200 may be capable of adjusting the spaced distance from the first plate 100 so that the spaced distance is adjusted to 0, and in this case, the second plate 200 may be in contact with the first plate 100.

The second plate 200 may have a predetermined thickness, and be provided in the form of a flat plate so that other components are disposed on one surface thereof.

The second plate 200 may include an electrical insulation material so that electricity does not flow therethrough.

The second connecting part 210 may be provided in one or more to be coupled to one side or each of both sides on one surface of the second plate 200. The second connecting part 210 may be a region coupled to a second electrode connecting part of the jig structure 2 of the measuring device 1 so as to be electrically connected to the second electrode.

The second connecting part 210 may include an electrically conductive metal material so that electricity flows therethrough. For example, the second connecting part 210 may include one or more of silver, copper, gold, aluminum, and tungsten, but is not limited thereto.

The second connecting part 210 may include a metal member in the form such as a metal piece, a metal bar, a metal rod, a metal stick, or a metal plate, which has a predetermined thickness and width. In this case, compared when connected in the form of a general wire, the second connecting part 210 may have a larger horizontal cross-sectional area to reduce electric resistance, and due to less movement, noise may be minimized from being input into the measuring device 1 for measuring the impedance spectrum, which outputs a signal sensitively to even a subtle flow of current.

A horizontal cross-section of the second connecting part 210 may have, for example, a polygonal shape such as square, rectangle, pentagon, or hexagon, a closed curve figure such as a circular shape or an oval shape, or the like, but the shape thereof is not limited thereto.

At least a portion of the second connecting part 210 may be disposed on the second plate 200, and the other portion thereof may be disposed at a side opposite to a direction, in which the first plate 100 is disposed, to protrude from a distal end of the second plate 200. The second connecting part 210 protruding from the distal end of the second plate 200 may be coupled to the second electrode connecting part of the jig structure 2.

The second connecting part 210 may have a bending shape. A distal end of the second connecting part 210 may extend by being bent to be perpendicular to a longitudinal direction of the connection unit 220. Accordingly, a coupling area with the second electrode connecting part of the jig structure 2 of the measuring device 1 may be increased to improve easiness in coupling.

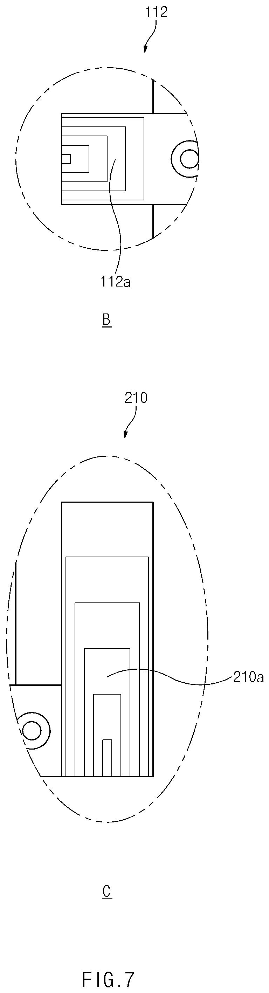

Referring to FIG. 7, a pattern groove 210a having a predetermined pattern may be defined in an end of one surface or each of both surfaces of the second connecting part 210. When the second connecting part 210 is connected to the second electrode connecting part of the measuring device 1, the pattern groove 210a may create friction to improve physical coupling force between the second connecting part 210 and the second electrode connecting part of the measuring device 1. In addition, the pattern groove 210a may increase a contact area with the first electrode connecting part of the jig structure 2 so as to allow current to flow well.

The second connecting part 210 may be in contact with and electrically connected to the connection unit 220 directly or through a medium.

The connection unit 220 is a component for connecting the first plate 100 and the second plate 200, and may be a component for moving the second plate 200 to adjust the spaced distance from the first plate 100.

The connection unit 220 may include an electrically conductive metal material so that electricity flows therethrough. For example, the connection unit 220 may include one or more of silver, copper, gold, aluminum, and tungsten, but is not limited thereto.

The connection unit 220 may include a metal member in the form such as a metal piece, a metal bar, a metal rod, a metal stick, or a metal plate, which has a predetermined thickness and width. In this case, compared when connected in the form of a general wire, the connection unit 220 may have a larger horizontal cross-sectional area to reduce electric resistance, and due to less movement, noise may be minimized from being input into the measuring device 1 for measuring the impedance spectrum, which outputs a signal sensitively to even a subtle flow of current.

A horizontal cross-section of the connection unit 220 may have, for example, a polygonal shape such as square, rectangle, pentagon, or hexagon, a closed curve figure such as a circular shape or an oval shape, or the like, but the shape thereof is not limited thereto.

The connection unit 220 may have one end that is coupled to the second plate 200, and the other end that is disposed on the guide unit 140 disposed on the first plate 100.

A slide hole 221 may be defined in the connection unit 220 in a longitudinal direction so that the connection unit 220 slidably moves on the guide unit 140.

The body part 130b of the coupling unit 130 may be inserted into the slide hole 221 so that an inner surface of the slide hole 221 is maintained to be in contact with the body part 130b of the coupling unit 130, and the inserted body part 130b may couple the fixing unit 120 disposed below the connection unit 220 to the first plate 100.

The connection unit 220 may adjust a position of the body part 130b, which is inserted into the slide hole 221, of the coupling unit 130 in the slide hole 221 to slide between the guide unit 140 and the fixing unit 120. Accordingly, the spaced distance between the second plate 200 and the first plate 100 may be adjusted.

The reference unit 300 may include a predetermined inherent numerical value, and the inherent numerical value may be an electrical or electronic numerical value.

The reference unit 300 may be a capacitor or a super capacitor. The reference unit 300 may generate an output signal by changing amplitude and phase while obstructing flow of input signals through impedance, which is a predetermined electrical/electronic numerical value, according to a frequency of input current and voltage signals.

The impedance of the reference unit 300 may be a resistance numerical value that changes according to a frequency of sinusoidal voltage and current input in the reference unit 300.

The reference unit 300 may be provided in one or plurality, and may be mounted on the mounting part 150 of the first plate 100. When the reference unit 300 is provided in plurality, the reference units 300 may be electrically connected in parallel. When the plurality of reference units 300 are provided and connected in parallel, the number of times that impedance of the reference unit 300 is measured for one charging of the reference units 300 may be increased to improve convenience of use.

The reference unit 300 may be connected to the fastening unit 113 and the coupling unit 130 through lead wires or the like by using a 4-wire resistive connection method. As the reference unit 300 is connected using the 4-wire resistive connection method, resistance, contact resistance or the like, which is generated due to the lead wires connected to the reference unit 300, may be reduced to minimize occurrence of errors.

Referring to FIG. 4, as one embodiment relating to a method for connecting a reference unit 300 according to the present invention to each of a fastening unit 113 and a coupling unit 130 through lead wires, when the reference unit 300 is provided in one, a first electrode pin provided in the reference unit may be redundantly connected to respective body parts 113b of a plurality of coupling units 130, through a plurality of lead wires. A second electrode pin provided in the reference unit 300 may be redundantly connected to respective body parts 130b of a plurality of coupling units 130 through a plurality of lead wires.

Referring to FIG. 5, as another embodiment relating to a method for connecting a reference unit 300 according to the present invention to each of a fastening unit 113 and a coupling unit 130 through lead wires, when the reference unit 300 is provided in plurality, a plurality of fastening units 113 may be redundantly connected to a first electrode pin of the reference unit 300, which is disposed to be most adjacent to the fastening units 113, through a plurality of lead wires, and first electrode pins of the reference units 300 may be connected to each other through one lead wire. In addition, a plurality of coupling units 130 may be redundantly connected to a second electrode pin of the reference unit 300, which is disposed to be most adjacent to the fastening units 113, through a plurality of lead wires, and second electrode pins of the reference units 300 may be connected to each other through one lead wire.

The body part 113b of the fastening unit 113 coupled to each of a plurality of linking units 112 may be in contact with and electrically connected to the linking unit 112.

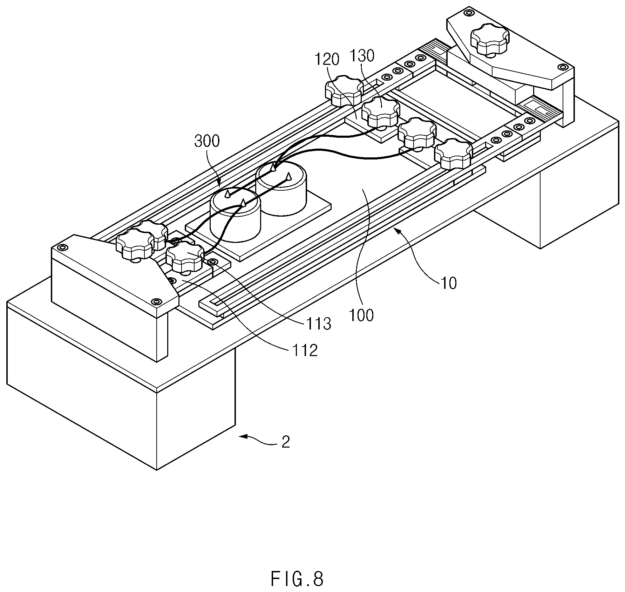

One embodiment of connecting a reference unit 300 and each of a first electrode and a second electrode of the measuring device 1 in the correcting device 10 according to the present invention will be described with reference to FIG. 8. A first electrode pin protruding from the reference unit 300 may be electrically connected to a linking unit 112 through an external lead wire that is in contact with a body part 113b of a fastening unit 113. A second electrode pin protruding from the reference unit 300 may be electrically connected to a fixing unit 120 through an external lead wire that is in contact with a body part 130b of a coupling unit 130.

However, the present invention is not limited thereto, and the external lead wire may be connected directly to each of the fixing unit 120 and the linking unit 112.

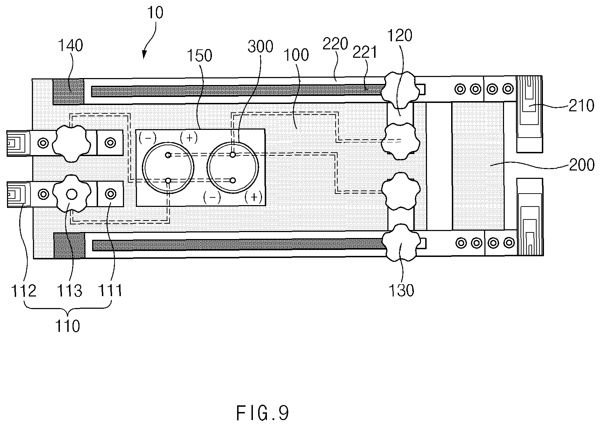

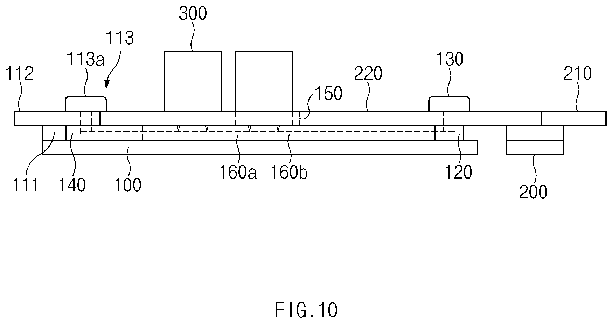

Another embodiment of connecting a reference unit 300 and each of a first electrode and a second electrode of the measuring device 1 will be described with reference to FIGS. 9 and 10. A first plate 100 may further include a first connecting unit 160a, which electrically connects a mounting part 150 to a linking unit 112, and a second connecting unit 160b which electrically connects the mounting part 150 to a fixing unit 120. The reference unit 300 may be electrically connected to the linking unit 112 and the fixing unit 120 through the connecting units 160a and 160b, respectively. Each of a first electrode pin and a second electrode pin of the reference unit 300 may face the mounting part 150. The first electrode pin may be electrically connected to the first connecting unit 160a electrically connected to the linking unit 112, and the second electrode pin may be electrically connected to the second connecting unit 160b electrically connected to the fixing unit 120.

The connecting units 160a and 160b may be disposed on an inner or bottom surface of the first plate 100 in a longitudinal direction of the first plate 100 so that the connecting unit 160a electrically connects the mounting part 150 to the linking unit 112, and the connecting unit 160b electrically connects the mounting part 150 to the fixing unit 120.

Each of the connecting units 160a and 160b may include an electrically conductive metal material so that electricity flows therethrough. For example, each of the connecting units 160a and 160b may include one or more of silver, copper, gold, aluminum, and tungsten, but is not limited thereto.

Each of the connecting units 160a and 160b may include a lead wire, a metal coating or a metal member in the form such as a metal piece, a metal bar, a metal rod, a metal stick, or a metal plate, which has a predetermined thickness and width. In a case in which each of the connecting units 160a and 160b has a shape of a metal piece, a metal bar, a metal rod, a metal stick, or a metal plate, or the like, when compared when connected in the form of a general wire, each of the connecting units 160a and 160b may have a larger cross-sectional area to reduce electric resistance, and due to less movement, noise may be minimized from being input into the measuring device 1 for measuring the impedance spectrum, which outputs a signal sensitively to even a subtle flow of current.

The connecting units 160a and 160b may be in contact with a body part 113b of the fastening unit 113 coupled to the first plate 100 and be electrically connected to the linking unit 112. Likewise, the connecting units 160a and 160b may be in contact with a body part 130b of the coupling unit 130 coupled to the first plate 100 and be electrically connected to the fixing unit 120.

As another embodiment of the present invention, a correcting method for correction of a measuring device 1 for measuring an impedance spectrum may include connecting a first electrode and a second electrode of the measuring device 1 to a first connecting part 110 and a second connecting part 210 of the correcting device 10, respectively, applying a sinusoidal input signal of current or a voltage to a reference unit 300, which electrically connects the first connecting part 110 to the second connecting part 210, through the measuring device 1, and outputting an output signal including an impedance spectrum in response to the applied input signal. The above correcting method may further include comparing and calculating a correction value with a predetermined electrical numerical value of the reference unit based on the output signal, and then correcting the measuring device.

Referring to FIG. 1, the measuring device 1 may include a jig structure 2, and several types of pouch type battery cells C having various sizes may be mounted on the jig structure 2. A first electrode and a second electrode of each of the battery cells C may be mounted on the jig structure 2 so as to correspond to a first electrode and a second electrode of the jig structure 2, respectively. The measuring device 1 may input sinusoidal alternating voltage and current into the battery cell C. Accordingly, the measuring device 1 may display the output signal, which is indicated by passing through the battery cell, to measure an impedance numerical value of the battery cell C. The displayed output signal may include a Bode plot, a Nyquist plot, and the like.

In order to measure accurate impedance, checking whether an initial value of the measuring device 1 is set correct is necessary before measuring of the impedance of the battery cell C through the measuring device 1. Accordingly, before the measuring of the impedance of the battery cell C, the correcting device 10 according to the present invention may be coupled to the measuring device 1 to measure impedance of the reference unit 300 coupled to the correcting device 10 and then the impedance of the reference unit 300 may be compared with impedance, which is a predetermined inherent electrical numerical value of the reference unit 300, to determine that when a value obtained by measuring the impedance matches the impedance that is an inherent electrical numerical value, the initial value of the measuring device 1 is set correct. However, when the value obtained by measuring the impedance does not match the impedance that is an inherent electrical numerical value, a correction value may be calculated based on a difference between the values. The initial value of the measuring device 1 may be corrected using the calculated correction value.

Referring to FIG. 2, as still another embodiment of the present invention, the present invention may provide a measuring device assembly including a measuring device 1 for measuring an impedance spectrum, a jig structure 2 electrically connected to each of a first electrode and a second electrode of the measuring device, and a correcting device 10 coupled to the jig structure 2. The correcting device 10 may include a first plate 100 including a first connecting part 110 electrically connected to the first electrode of the measuring device 1, a second plate 200 including a second connecting part electrically connected to the second electrode of the measuring device 1, and a reference unit 300 mounted on the first plate 100 and having a predetermined electrical numerical value. The first connecting part 110 and the second connecting part 210 may be electrically connected to each other through the reference unit 300. The correcting device 10 coupled to the jig structure 2 is the same as that described above.

The jig structure 2 may include a first electrode connecting part 3, a second electrode connecting part 4, and a seating part 5.

The first electrode connecting part 3 may be disposed on one end of the jig structure 2, and be electrically connected to the first electrode of the measuring device 1. The first electrode connecting part 3 may be coupled and electrically connected to a linking unit 112 of the correcting device 10. The first electrode connecting part 3 may be electrically connected to the reference unit 300 through a 4-wire resistive connection method. The first electrode connecting part 3 may include a plurality of first upper plates and a first lower plate, each of which includes an electrically conductive metal material. A plurality of linking units 112 may be disposed on the first lower plate, and the plurality of first upper plates may be disposed on top surfaces of the linking units 112, respectively. The first lower plate and the first upper plate may press the linking unit 112 disposed therebetween to be coupled and electrically connected to the linking unit 112. A plurality of second upper plates may be spaced a predetermined distance from each other. An electric insulator may be attached to a bottom surface of one of the plurality of linking units 112 so that the plurality of linking units 112 are not electrically connected to each other through the first lower plate, and the 4-wire resistive connection method is maintained. The second electrode connecting part 4 may be disposed on the other end of the jig structure 2, and be electrically connected to the second electrode of the measuring device 1. The second electrode connecting part 4 may be coupled and electrically connected to a second connecting part 210 of the correcting device 10. The second electrode connecting part 4 may be electrically connected to the reference unit 300 through a 4-wire resistive connection method. The second electrode connecting part 4 may include a plurality of second upper plates and a second lower plate, each of which includes an electrically conductive metal material. A plurality of connecting parts 210 may be disposed on the second lower plate, and the plurality of second upper plates may be disposed on top surfaces of the connecting parts 210, respectively. The second lower plate and the second upper plate may press the connecting part 210 disposed therebetween to be coupled and electrically connected to the connecting part 210. The plurality of second upper plates may be spaced a predetermined distance from each other. An electric insulator may be attached to a bottom surface of one of the plurality of connecting parts 210 so that the plurality of connecting parts 210 are not electrically connected to each other through the second lower plat, and the 4-wire resistive connection method is maintained.

The seating part 5 may be disposed between the first electrode connecting part 3 and the second electrode connecting part 4 and be a region for seating the correcting device 10 or the battery cell C. The seating part 5 may have a top surface having a flat shape so that the correcting device 10 or the battery cell C is stably seated thereon.

Although the present invention has been described with reference to the limited embodiments, the present invention is not limited thereto. Changes and modifications to the embodiments can be made without departing from the spirit and scope of the present invention, and those with ordinary skill in the technical field of the present invention pertains will be understood that these changes and modifications are to be regarded to be in the scope of the present invention.

### [Description of the Symbols]

1: Measuring device
10: Correcting device
100: First plate
110: First connecting part
111: Support unit
112: Linking unit
113: Fastening unit
113a: Head part
113b: Body part
120: Fixing unit
130: Coupling unit
130a: Head part
130b: Body part
140: Guide unit
150: Mounting part
200: Second plate
210: Second connecting part
220: Connection unit
221: Slide hole
300: Reference unit

## Claims

1. A correcting device for correction of a measuring device configured to measure an impedance spectrum, the correcting device comprising:
a first plate comprising a first connecting part electrically connected to a first electrode of the measuring device;
a second plate comprising a second connecting part electrically connected to a second electrode of the measuring device; and
a reference unit mounted on the first plate and having a predetermined electrical numerical value,
wherein the first connecting part and the second connecting part are electrically connected to each other through the reference unit.

2. The correcting device of claim 1, wherein the reference unit is configured so that the impedance spectrum is measured by the measuring device.

3. The correcting device of claim 1, wherein the first plate further comprises a fixing unit electrically connected to the first connecting part through the reference unit, and
the second plate further comprises a connection unit that is in contact with the fixing unit to electrically connect the fixing unit to the second connecting part.

4. The correcting device of claim 3, wherein the connection unit is in contact with the fixing unit.

5. The correcting device of claim 3, wherein a slide hole is defined in the connection unit in a longitudinal direction,
wherein a coupling unit is inserted into the slide hole, and the inserted coupling unit is coupled to the fixing unit.

6. The correcting device of claim 1, wherein the reference unit is a capacitor.

7. The correcting device of claim 1, wherein the first plate further comprises a mounting part in which an accommodation space in which the reference unit is mounted is defined.

8. The correcting device of claim 3, wherein the first plate further comprises a guide unit disposed in a longitudinal direction of the first plate, and disposed below the connection unit.

9. The correcting device of claim 8, wherein the guide unit has a height that is the same as a height of the fixing unit.

10. The correcting device of claim 3, wherein each of the fixing unit and the connection unit comprises a metal member.

11. A correcting method for correction of a measuring device configured to measure an impedance spectrum, the correcting method comprising:
connecting a first electrode and a second electrode of the measuring device to a first connecting part and a second connecting part of the correcting device, respectively;
applying a sinusoidal input signal to a reference unit configured to electrically connect the first connecting part to the second connecting part through the measuring device; and
outputting an output signal comprising the impedance spectrum in response to the applied input signal.

12. The correcting method of claim 11, further comprising comparing and calculating a correction value with a predetermined electrical numerical value of the reference unit in response to the output signal, and then correcting the measuring device to the correction value.

13. The correcting method of claim 11, wherein the output signal comprises one or more of a Bode plot and a Nyquist plot.

14. A measuring device assembly comprising:
a measuring device configured to measure an impedance spectrum;
a jig structure electrically connected to each of a first electrode and a second electrode of the measuring device; and
a correcting device coupled to the jig structure,
wherein the correcting device comprises:
a first plate comprising a first connecting part electrically connected to the first electrode of the measuring device;
a second plate comprising a second connecting part electrically connected to the second electrode of the measuring device; and
a reference unit mounted on the first plate and having a predetermined electrical numerical value,
wherein the first connecting part and the second connecting part are electrically connected to each other through the reference unit.
